# EUROPEAN PATENT APPLICATION

(11) **EP 4 531 219 A1**
(43) Date of publication of application: **02.04.2025**
(21) Application number: 24198001.0
(22) Date of filing: 02.09.2024
(51) Int. Cl.: H02H 3/16, G01R 31/08, H02H 3/33, H02H 5/12

(54) **GROUND FAULT INTERRUPT FOR HVAC EQUIPMENT OUTLET DISCONNECT**

(30) Priority: 29.09.2023 US 202363541722 P; 16.04.2024 US 202418636959
(71) Applicant: Schneider Electric USA, Inc., Andover, MA 01810 (US)
(72) Inventor: REID, Paul A., Cedar Rapids, IA (US); LARSON, Brett E., Cedar Rapids, IA (US)
(74) Representative: Manitz Finsterwald Patent- und Rechtsanwaltspartnerschaft mbB

(57) **Abstract**

Protection systems and methods for providing ground fault detection in heating, ventilating, and air conditioning equipment (102). The protection systems and methods allow an appropriate or safe level of grounding conductor leakage current from the equipment while at the same time providing let-go current protection for branch circuit conductors feeding the equipment. In some embodiments, the systems and methods herein are implemented in the form of a ground fault interrupting system (110) that is specifically designed to operate outdoors, and may be installed at the equipment outlet disconnect device typically mounted on an exterior wall near the equipment. In some embodiments, the ground fault interrupting system incorporates the outlet disconnect device therein. In either case, the ability of the ground fault interrupting system to be located outdoors near the equipment allows technicians to more easily install, access, and service the ground fault interrupting system compared to an indoor arrangement.

Fig. 1

## Description

### CROSS-REFERENCE TO RELATED APPLICATIONS

This application for patent claims the benefit of priority to and incorporates herein by reference U.S. Provisional Application No. 63/541,722, entitled "Ground Fault Interrupt for HVAC Equipment Outlet Disconnect," filed September 29, 2023.

### TECHNICAL FIELD

Embodiments of the present disclosure relate to heating, ventilating, and air conditioning (HVAC) systems and, more particularly, to systems and methods for improving ground fault detection in such systems.

### BACKGROUND

Modern HVAC systems use variable speed drives and electronically controlled motors to maximize efficiency. Variable speed drives are used to adjust the speed of the compressor and/or motor that rotates the external HVAC fan unit to move air through the system. A drawback of these variable speed drive systems is increased electrical noise on power supply lines produced by high-frequency switching needed to drive the motors. Noise filtering components can be added to the HVAC equipment to mitigate the high-frequency electrical noise, but these components can cause leakage current to flow through the grounding conductor of the power supply lines. The leakage current flowing through the grounding conductor can be at line frequency and/or higher switching frequencies and may exceed in amplitude generally accepted ground fault current thresholds for GFCI circuit breakers at the electrical panel, which can cause frequent tripping of the GFCI circuit breakers. In short, HVAC equipment is currently allowed to produce a leakage current level that is higher than ground fault current thresholds for existing GFCI circuit breakers installed at the electrical panel, outlet, or disconnect.

### SUMMARY

Embodiments of the present disclosure relate to systems and methods for improving ground fault detection in HVAC equipment as well as other types of equipment and appliances. The systems and methods provide an improved approach to ground fault detection for such equipment that can accommodate an appropriate or safe level of grounding conductor leakage current from the equipment while at the same time providing let-go current protection for branch circuit conductors feeding the equipment. In some embodiments, the systems and methods herein are implemented in the form of a ground fault interrupting system that is specifically designed to operate outdoors and may be installed at the equipment outlet disconnect device typically mounted on an exterior wall. In some embodiments, the ground fault interrupting system incorporates the outlet disconnect device therein. The ability of the ground fault interrupting system to be located near outdoor equipment allows technicians to install, access, and service the ground fault interrupting system more easily compared to an indoor arrangement.

In general, in one aspect, embodiments of the present disclosure relate to a ground fault monitoring and detection system. The system comprises, among other things, a current interrupt switch configured to be connected to power supply lines. The system additionally comprises a first leakage sensor connected to the current interrupt switch, the first leakage sensor configured to detect a leakage current in the power supply lines and to control the current interrupt switch to interrupt current through the power supply lines if the leakage current exceeds a first current threshold. The system further comprises a second leakage sensor connected to the current interrupt switch, the second leakage sensor configured to detect the leakage current in the power supply lines and to control the current interrupt switch to interrupt current through the power supply lines if the leakage current exceeds a second current threshold. In one embodiment, the first current threshold is a let-go current and the second current threshold is greater than the let-go current by a predefined amount.

In general, in another aspect, embodiments of the present disclosure relate to a method of providing ground fault monitoring and detection. The method comprises, among other things, providing a current interrupt switch configured to be connected to power supply lines. The method additionally comprises connecting a first leakage sensor to the current interrupt switch, the first leakage sensor configured to detect a leakage current in the power supply lines and to control the current interrupt switch to interrupt current flow through the power supply lines if the leakage current exceeds a first current threshold. The method further comprises connecting a second leakage sensor to the current interrupt switch, the second leakage sensor configured to detect the leakage current in the power supply lines and to control the current interrupt switch to interrupt current flow through the power supply lines if the leakage current exceeds a second current threshold. In one embodiment, the first current threshold is a let-go current and the second current threshold is greater than the let-go current by a predefined amount.

In general, in yet another aspect, embodiments of the present disclosure relate to a heating, ventilating, and air conditioning (HVAC) system. The HVAC system comprises, among other things, an electrical panel, power supply lines connected to the electrical panel, HVAC equipment connected to the power supply lines, and a current interrupt switch connected to the power supply lines between the electrical panel and the HVAC equipment. The system additionally comprises a first leakage sensor connected to the current interrupt switch, the first leakage sensor configured to detect a leakage current in the power supply lines and to control the current interrupt switch to interrupt current to the HVAC equipment if the leakage current exceeds a first current threshold. The system further comprises a second leakage sensor connected to the current interrupt switch, the second leakage sensor configured to detect the leakage current in the power supply lines and to control the current interrupt switch to interrupt current to the HVAC equipment if the leakage current exceeds a second current threshold. In one embodiment, the first current threshold is a let-go current and the second current threshold is greater than the let-go current by a predefined amount.

In accordance with any one or more of the foregoing embodiments, the first leakage sensor comprises a first ground fault interrupt device (GFID) connected to a first current sensor, and the second leakage sensor comprises a second GFID connected to a second current sensor.

In accordance with any one or more of the foregoing embodiments, the power supply lines include a first ungrounded conductor, a second ungrounded conductor, and a grounding conductor, and the second leakage sensor is configured to detect the leakage current via the first and second ungrounded conductors, while the first leakage sensor is configured to detect the leakage current via the first and second ungrounded conductors and also the grounding conductor.

In accordance with any one or more of the foregoing embodiments, the current interrupt switch is a load side current interrupt switch, the system further comprising a line side current interrupt switch configured to be connected to the power supply lines.

In accordance with any one or more of the foregoing embodiments, a supervisory controller is connected to the line side current interrupt switch, the supervisory controller is configured to control the line side current interrupt switch to interrupt current flow through the power supply lines upon occurrence of a predefined current interrupt event.

In accordance with any one or more of the foregoing embodiments, a local disconnect handle is mechanically coupled to the line side current interrupt switch, the local disconnect handle is configured to be operated by a user to manually interrupt current flow through the power supply lines.

In accordance with any one or more of the foregoing embodiments, a housing is configured to enclose the current interrupt switch and the first and second leakage sensors, the housing providing weather protection for the current interrupt switch and the first and second leakage sensors.

In accordance with any one or more of the foregoing embodiments, the supervisory controller is coupled to the first and second leakage sensors, the supervisory controller configured to perform diagnostics on the leakage current detected by the first and second leakage sensors and provide status and diagnostic information to a user.

### BRIEF DESCRIPTION OF THE DRAWINGS

The foregoing and other advantages of the disclosed embodiments will become apparent upon reading the following detailed description and upon reference to the drawings, wherein:
FIG. 1 illustrates a high-level view of an exemplary system equipped with a ground fault interrupting system in accordance with embodiments of this disclosure;
FIG. 2 illustrates a circuit diagram for an exemplary system equipped with a ground fault interrupting system in accordance with embodiments of this disclosure;
FIG. 3 illustrates leakage current in an exemplary system equipped with a ground fault interrupting system in accordance with embodiments of this disclosure;
FIG. 4 illustrates another leakage current in an exemplary system equipped with a ground fault interrupting system in accordance with embodiments of this disclosure;
FIG. 5 illustrates yet another leakage current in an exemplary system equipped with a ground fault interrupting system where the grounding conductor is open in accordance with embodiments of this disclosure;
FIG. 6 illustrates how an open ungrounded conductor is addressed in an exemplary system equipped with a ground fault interrupting system in accordance with embodiments of this disclosure;
FIG. 7 illustrates an exemplary method that may be used in an exemplary system equipped with a ground fault interrupting system in accordance with embodiments of this disclosure;
FIG. 8 is a functional block diagram of a general-purpose computer system that may be used to implement various embodiments of this disclosure; and
FIG. 9 is a functional block diagram of a general-purpose storage system that may be used to implement various embodiments of this disclosure.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

As mentioned above, high-frequency leakage current combined with line frequency leakage current from HVAC equipment can increase the current flowing through the grounding conductor in power supply lines beyond accepted ground fault current thresholds, which can result in frequent tripping of GFCI circuit breakers. Existing GFCI circuit breakers can provide some accommodation for the high-frequency leakage current from the HVAC equipment by tuning the GFCI response to ignore some of the high-frequency leakage current. However, existing GFCI breakers do not address situations in which line frequency leakage current exceeds let-go current, which is generally considered to be from 4 mA to 6 mA, although a lower threshold current value of 3.5 mA may also be allowed in high or low ambient temperature conditions.

Embodiments of the present disclosure provide systems and methods that protect against line frequency leakage current values above let-go current. The embodiments described herein provide let-go protection against electric shock from each ungrounded conductor to Earth ground while also allowing the normal leakage current from HVAC and other types of equipment and appliances to flow back to the power source through the grounding conductor. These embodiments allow up to 15 mA of line frequency leakage current to flow to ground within the equipment, which allows the equipment to operate within the normal leakage current range. Leakage current that flows from the ungrounded conductors to Earth ground is detected at 6 mA, similar to a Class A GFCI.

In some embodiments, the systems and methods herein may be implemented as a ground fault interrupting system developed specifically for installation at the outdoor outlet disconnect location near HVAC equipment. This greatly benefits technicians when installing and troubleshooting the ground fault interrupting system, as the system reset switch and other components can be accessed directly at the outdoor disconnect near the equipment rather than at the main electrical panel.

The ground fault interrupting system herein can be powered and operated from the two ungrounded conductors that are normally available at the outlet disconnect, and thus does not require the additional neutral conductor that may not be available in existing installations. In addition, the ground fault interrupting system herein may incorporate controllable disconnecting contacts that open automatically when voltage between the ungrounded conductors is not available. This helps mitigate instances where power is lost to one of two ungrounded conductors, which would normally result in loss of protection for the ungrounded conductor that remains powered.

The ground fault interrupting system herein may also include monitoring, status, and/or diagnostic function (i.e., supervisory controller) that provides information about the status of the system to the user. This information can be provided to the user remotely through a wired or wireless communications system, as well as locally through a user interface on the device itself (e.g., LEDs, LCD display, etc.). The status or diagnostic information can provide the user or technician with notifications about abnormal or unusual current flow, such as when the leakage current exceeds an expected range but is still below the level at which the system will trip, or information about the level of leakage current present when the system tripped, and the like. Other benefits and advantages of the ground fault interrupting system disclosed herein will be readily apparent to those having ordinary skill in the art.

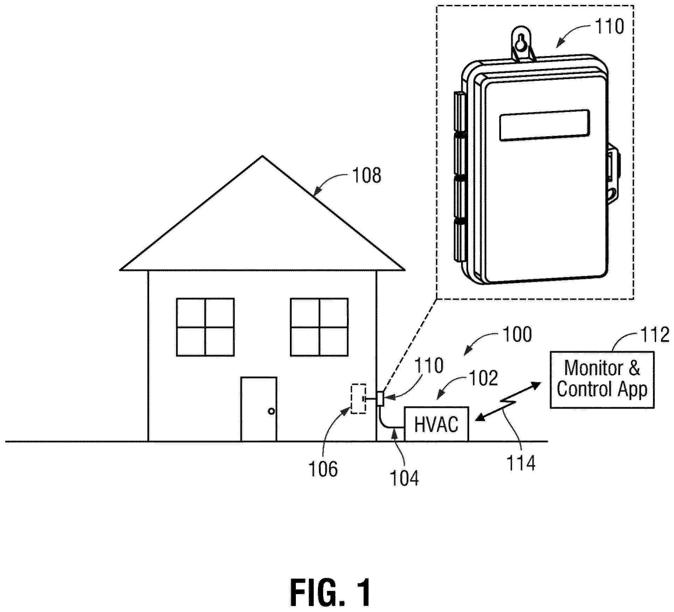

Referring now to FIG. 1, a high-level diagram is shown for an exemplary system equipped with a ground fault interrupting system in accordance with embodiments of this disclosure. The exemplary system, designated here as 100, is a residential HVAC system that includes an outdoor compressor unit 102 connected by power supply lines 104 to an electrical panel 106 at a residential dwelling 108. Operation of the HVAC system 100 is generally known to those skilled in the art and thus a detailed description is omitted here for economy. Suffice it to say, the electrical panel 106 connects AC line current from a utility power source to the power supply lines 104 to provide current to the compressor unit 102 to operate the compressor unit. Although a residential HVAC system 100 is shown and described herein, it will be understood that embodiments of the present disclosure may also be used with industrial/commercial HVAC installations, as well as other types of equipment and appliances, whether industrial/commercial or residential, that can benefit from an external or outdoor ground fault interrupting system. Exemplary equipment and appliances may include yard heaters, porch stoves, hot tubs, and the like.

In accordance with embodiments of the present disclosure, instead of a typical outdoor outlet disconnect, the system 100 herein includes an outdoor ground fault interrupting system 110. The ground fault interrupting system 110 is installed in the power supply lines 104 between the compressor unit 102 and the electrical panel 106, and provides not only manual disconnect capability similar to an outlet disconnect, but also ground fault and let-go current detection capability heretofore not found at an outdoor disconnect. This allows the system 100 to operate normally without requiring a GFCI breaker in the electrical panel 106, yet still protect against let-go current levels and resulting electric shock. Preferably the ground fault interrupting system 110 has a weatherproof housing, such as molded case housing, that allows the system 110 to maintain operational integrity even in severe weather. The ground fault interrupting system 110 can then be implemented in the form of a circuit breaker or similar circuit interrupt device enclosed within such a housing.

In some embodiments, the ground fault interrupting system 110 is configured to communicate with an external monitoring and control application, or app, 112 that monitors the current flowing through the power supply lines 104 for diagnostic purposes. The monitoring and control app 112 may reside on a local device, such as a smart phone or tablet, and may be run over a wired or wireless network 114. The network 114 over which the monitoring and control app 112 runs may be a local residential network, an enterprise network, or a cloud-based network in some embodiments. Examples of suitable external monitoring and control apps that may be used as the monitoring and control app 112 include Wiser Monitor available from Schneider Electric, and the like. Such a monitoring and control app 112 may then receive the status or diagnostic information mentioned above and display or otherwise provide the information to the user or technician in the form of one or more notifications, warnings, and alerts.

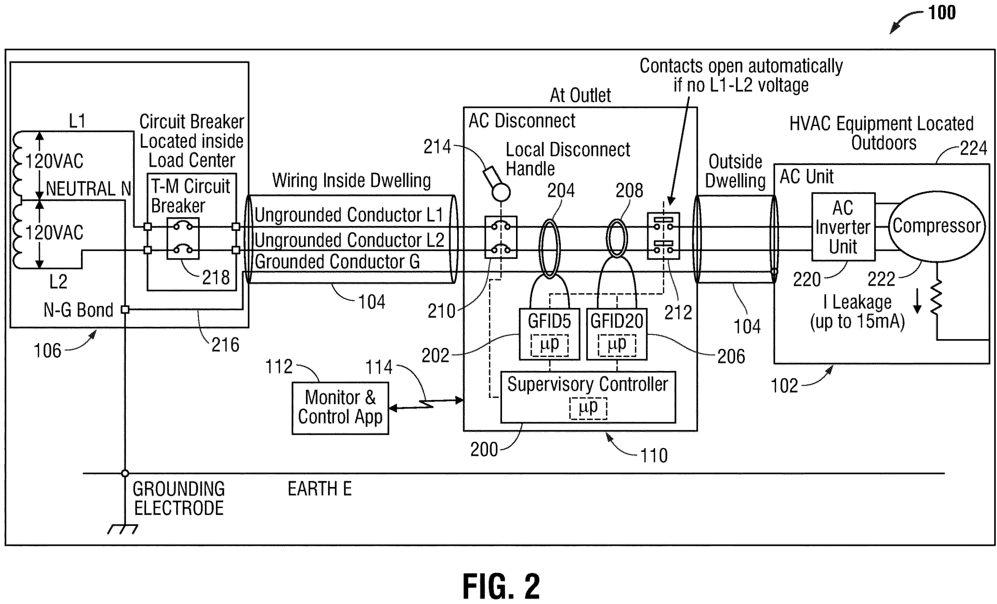

FIG. 2 shows a circuit diagram for the system 100 and the ground fault interrupting system 110 in accordance with embodiments of this disclosure. As can be seen, the power supply lines 104 for the system 100 include a first ungrounded conductor "L1," a second ungrounded conductor "L2," and a grounding conductor "G," all connected as shown. These power supply lines 104 (i.e., branch circuit conductors) carry AC line current from the electrical panel 106 to the ground fault interrupting system 110 and from the system 110 to the compressor unit 102. A neutral conductor "N" and Earth ground "E" are also depicted here for completeness.

The ground fault interrupting system 110 has a number of functional components that are shown as discrete blocks, any one of which may be divided into two or more constituent blocks, and/or any two of which may be combined into a single block, depending on the implementation. In this example, the ground fault interrupting system 110 has a supervisory controller 200 that is communicatively coupled with and operable to control dual ground fault sensors. The first ground fault sensor is a low leakage sensor composed of a low current ground fault interrupt device ("GFID5") 202 connected to a first current sensor 204 that senses current flowing through the two ungrounded conductors L1 and L2 and the grounding conductor G. This first current sensor 204 may be a current transformer in some embodiments that encircles or is otherwise electromagnetically coupled to the two ungrounded conductors L1 and L2 and the grounding conductor G. The second ground fault sensor is a high leakage sensor composed of a high current ground fault interrupt device ("GFID20") 206 connected to a second current sensor 208 that senses current flowing through only the two ungrounded conductors L1 and L2. This second current sensor 208 may also be a current transformer in some embodiments that encircles is otherwise electromagnetically coupled to the two ungrounded conductors L1 and L2.

Also present in the ground fault interrupting system 110 are two double-pole contact switches, namely, a line side contact switch 210 and a load side contact switch 212. The line side contact switch 210 is connected to and controllable by the supervisory controller 200 to interrupt current flow through the ungrounded conductors L1 and L2 based on any abnormal or unusual current flow detected by the supervisory controller 200, as mentioned above. In addition, the line side contact switch 210 is also connected to and controllable by a local disconnect handle 214 mechanically coupled to the line side contact switch 210. The disconnect handle 214 allows a technician to manually control the contact switch 210, as indicated by the dashed lines, to interrupt current flow through the ungrounded conductors L1 and L2. The load side contact switch 212 is independently controllable by both the low current ground fault interrupt device 202 and the high current ground fault interrupt device 206, as indicated by the dashed lines. It should be understood that other types of switches and relays that can interrupt current flow in a conductor may also be used besides the double-pole contact switches mentioned above, such as solid-state switches, electromechanical relays, and other current interrupt switches.

In general, the supervisory controller 200, or rather its functionality, may be implemented using any suitable processing unit that can execute program code, including a microprocessor (µP), microcontroller, application specific integrated circuit (ASIC), programmable logic controllers (PLC), field programmable gate array (FGPA), and the like, or be an analog or digital detection circuit implementing the same function. Likewise, the low and high current ground fault interrupt devices 202 and 206, or rather their functionality, may be implemented using any suitable processing unit that can execute program code, including a microprocessor, microcontroller, ASIC, FPGA, and the like, or be an analog or digital detection circuit implementing the same function.

With the ground fault detection and interrupt capability of the ground fault interrupting system 110 disclosed herein, it is no longer necessary for residential dwellings to include GFCI capability at the electrical panel 106 feeding the HVAC unit 102, as ground fault detection and circuit interrupt can now be provided by the ground fault interrupting system 110. Indeed, in the example shown, a simple thermal-magnetic circuit breaker 216 can be used with the electrical panel 106.

As for the HVAC unit 102, in this example, the unit 102 includes a high-frequency AC inverter unit 220 and an HVAC compressor 222 housed within a metal casing or housing 224. The AC inverter unit 220, as its name implies, operates to convert the AC line current from the two ungrounded conductors L1 and L2 into a form usable by the compressor 222. The compressor 222, meanwhile, is knowingly permitted to produce a leakage current of up to 15 mA during normal operation.

Operation of the ground fault interrupting system 110 is generally as follows. The low current ground fault interrupting device 202 provides 6 mA ground fault protection (i.e., let-go current) for leakage current from either of the ungrounded conductors L1 or L2 to Earth ground E. The high current ground fault interrupt device 202, on the other hand, provides 15-20 mA leakage protection for leakage current from either of the ungrounded conductors L1 or L2 through the metal casing or housing 224 flowing back through the grounding conductor G. No ground monitor is needed. Instead, the low current ground fault interrupt device 202 will detect any current flowing to Earth ground E through the metal casing or housing 224 of the compressor 222 (e.g., around 5 mA) when the grounding conductor G is open, and automatically cause the load side contacts 212 to open.

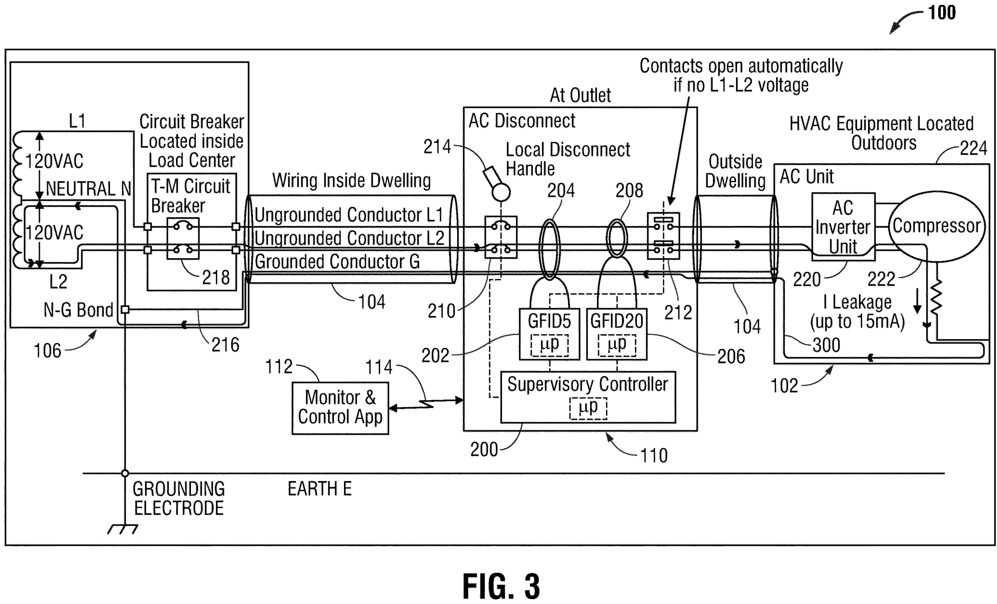

FIG. 3 shows an example of the ground fault interrupting system 110 in operation with normal leakage current of 15 mA from the compressor 222. In this example, normal compressor leakage current, designated here as 300, flows from the second ungrounded conductor L2 through the casing 224 of the compressor 222 and returns through the grounding conductor G. This leakage current 300 is canceled out at the first current sensor 204, as the second ungrounded conductor L2 and the grounding conductor G both pass through that current sensor 204. Therefore, the leakage current 300 is not detected by the low current ground fault interrupt device 202, so the device 202 does not open the load side contacts 212, and the compressor 222 is permitted to continue operating.

On the other hand, the leakage current 300 is not canceled out at the second current sensor 208, so it gets detected by the high current ground fault interrupt device 206. But since the leakage current 300 does not exceed the 15-20 mA current threshold of the high current ground fault interrupt device 206, the device 206 does not automatically open the load side contacts 212, and the compressor 222 is permitted to continue operating. In this way, the ground fault interrupting system 110 is able to accommodate a normal amount of leakage current from the compressor 222 up to 15 mA. In contrast, existing ground fault interrupt devices would have to trip as soon as the compressor leakage current 300 exceeds 6 mA.

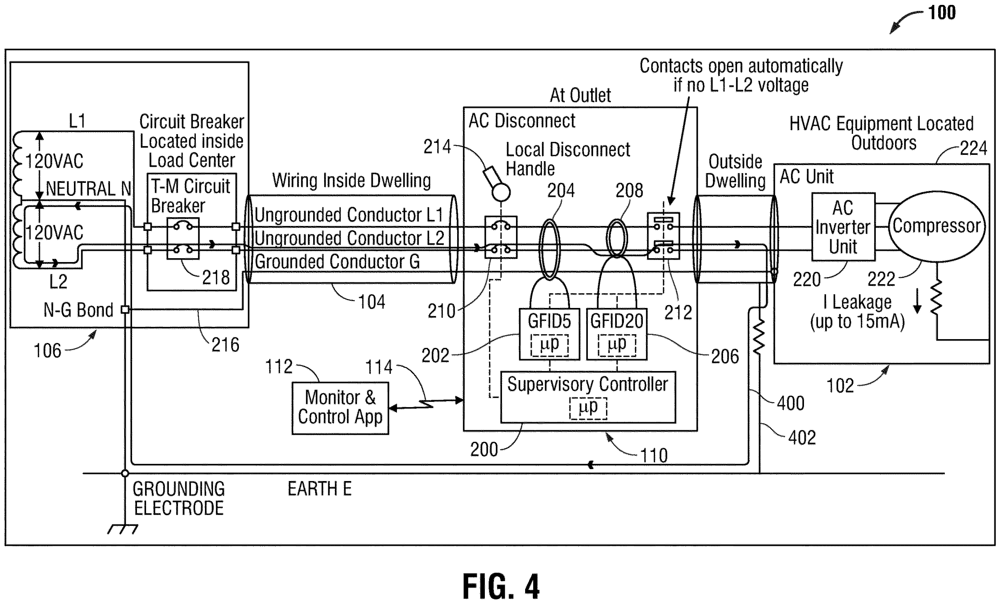

FIG. 4 shows another example of the ground fault interrupting system 110 in operation with normal leakage current of 15 mA from the compressor 222. In this example, however, the intended path of the compressor leakage current, designated here as 400, has been rerouted from the grounding conductor G through Earth ground E instead. This scenario can occur, for example, if the second ungrounded conductor L2 came into contact with a person standing on the ground. That person will suddenly establish a path from the second ungrounded conductor L2 to the Earth ground E, designated here as 402. When this happens, the AC line current from the ungrounded conductor L2 bypasses the grounding conductor G, flowing instead through the new path 402 and returning through the Earth ground E. As a result, the leakage current 400 is no longer canceled out at the first current sensor 204, and can now be detected by the low current ground fault interrupt device 202. Since this leakage current 400 is greater than the 6 mA threshold of the low current ground fault interrupt device 202, the device 202 automatically opens the load side contacts 212 to interrupt the current flow to the compressor 222.

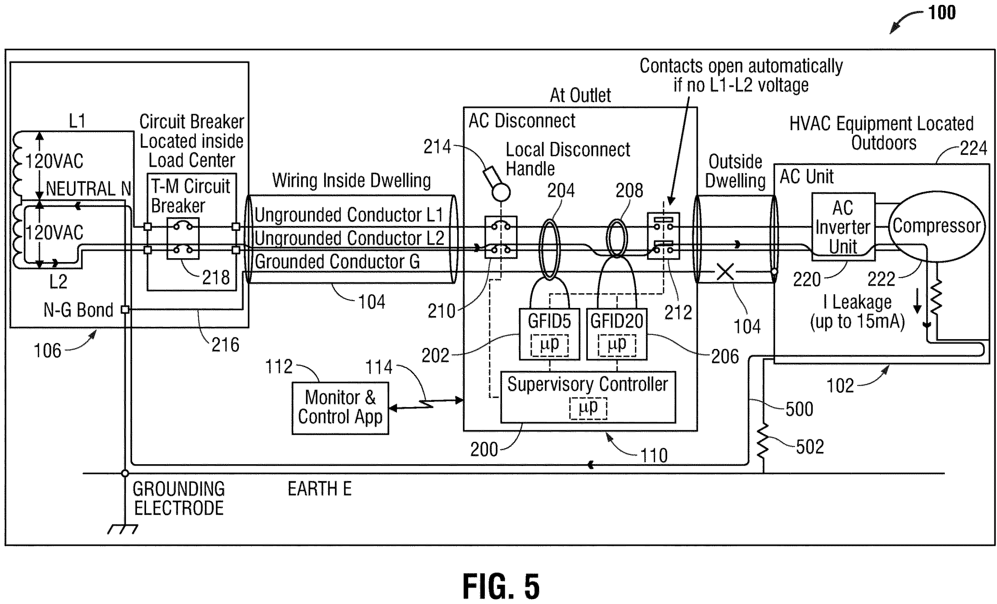

FIG. 5 shows yet another example of the ground fault interrupting system 110 in operation with normal leakage current of 15 mA from the compressor 222. In this example, the intended path of the compressor leakage current, designated here as 500, has again been rerouted from the grounding conductor G through Earth ground E instead. In the scenario, the grounding conductor G has been broken or disconnected from the casing of the compressor 222, such that a voltage potential develops on the casing due to AC line current continuing to flow through the compressor 222 from the second ungrounded conductor L2. A person standing on the ground who happens to touch the casing 224 of the compressor 222 will suddenly establish a path to Earth ground E, designated here as 502. When this happens, the AC line current from the conductor L2 again bypasses the grounding conductor G and returns through the Earth ground E. As a consequence, the leakage current 500 is no longer canceled out at the first current sensor 204 and can now be detected by the low current ground fault interrupt device 202. Because this leakage current 500 is greater than the 6 mA threshold of the low current ground fault interrupt device 202, the device 202 again automatically opens the load side contacts 212 to interrupt the current flow to the compressor 222.

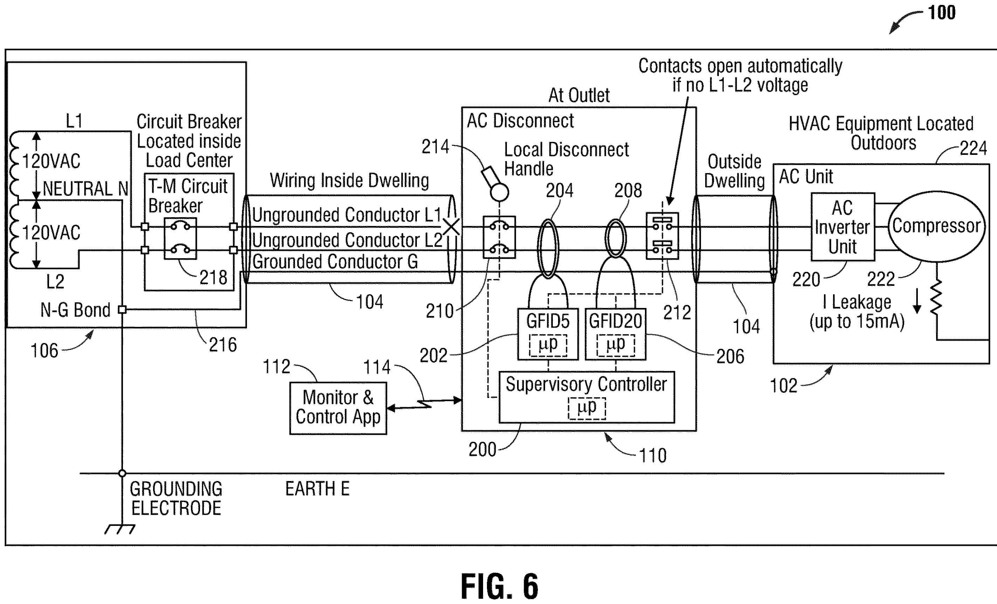

FIG. 6 shows still another example of the ground fault interrupting system 110 in operation with normal leakage current of 15 mA from the compressor 222. In this example, one of the line side ungrounded conductors, the first ungrounded conductor L1 for instance, has been broken or become disconnected. When this happens, the load side contacts 212 are configured to open automatically, as no power is available at the ground fault interrupting system 110 to detect the disconnect. To achieve this automatic opening of the contacts 212, in some embodiments, the contacts 212 are configured in a normally open configuration such that they open automatically when power is removed. In a similar manner, the supervisory controller 200 may also detect contact welding of the line side contacts 210 or the load side contacts 212, which can occur when a sufficiently high current flows through the contacts. Upon detecting such contact welding, the supervisory controller 200 again automatically opens the line side or load side contacts 210 or 212, as the case may be, or causes the contacts to be opened via the low current device 202 or the high current device 206, for example.

In the foregoing examples, the compressor leakage current was described as flowing through the second ungrounded conductor L2. It will be appreciated, however, that the compressor leakage current can also flow through the first ungrounded conductor L1, and that in general, the principles and teachings discussed herein apply equally to either case.

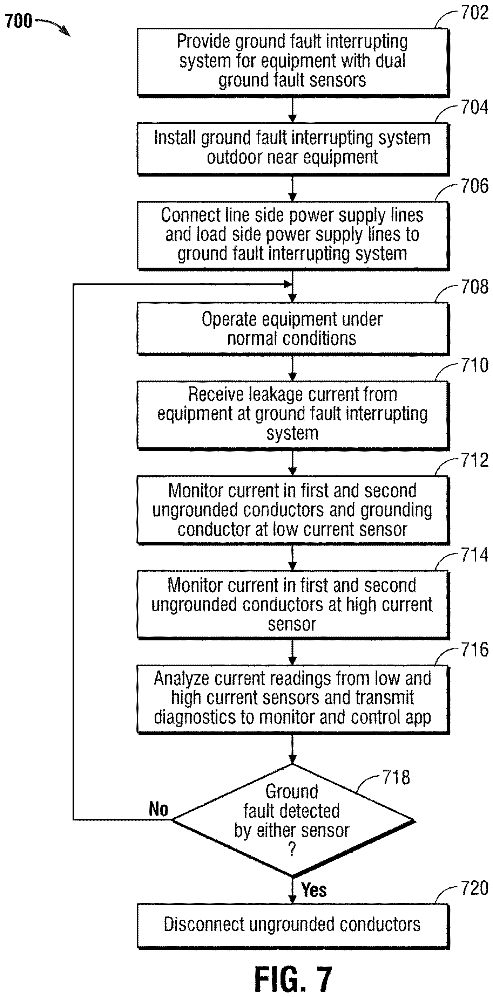

Turning now to FIG. 7, a flowchart 700 is shown representing an exemplary method that may be used by or with embodiments of the present disclosure herein. The method generally begins at block 702 where a ground fault interrupting system for equipment having dual ground fault sensors is provided. The equipment may be HVAC equipment in this example, or the equipment may be any type of equipment that can benefit from the method of interrupting a ground fault outdoors disclosed herein. The dual ground fault sensors include a low current sensor and a high current sensor similar to the low current and high current sensors discussed above in some embodiments. Thus, in some embodiments, the first ground fault sensor has a low leakage sensor composed of a low current ground fault interrupt device connected to a first current sensor, which may be a current transformer, and the second ground fault sensor has a high leakage sensor composed of a high current ground fault interrupt device connected to a second current sensor, which may also be a current transformer. In addition, both ground fault sensors are connected to and can independently control a set of load side contacts similar to that discussed above.

At block 704, the ground fault interrupting system is installed or mounted outdoors near the equipment, for example on an exterior wall of a residential dwelling. At block 706, line side power supply lines and load side power supply lines are connected to the line side and load side, respectively, of the ground fault interrupting system. The power supply lines typically include a first ungrounded conductor, a second ungrounded conductor, and a grounding conductor, arranged in a similar manner to that discussed above. Thus, current through the first and second ungrounded conductors and the grounding conductor are sensed by the first current sensor, while the second current sensor senses only current through the two ungrounded conductors. In some embodiments, the power supply lines may also include a neutral conductor (grounded conductor) in addition to the grounding conductors and the ungrounded conductor.

At block 708, the equipment is operated under normal operating conditions in which the equipment is known to produce a leakage current of up to 15 mA. At block 710, the leakage current from the equipment is received at the ground fault interrupting system. At block 712, current in the first and second ungrounded conductors and the grounding conductor are monitored at the low current sensor. At block 714, current in the first and second ungrounded conductors are monitored at the high current sensor. At block 716, the current readings from the low and the high current sensors are analyzed and any diagnostics are transmitted to a monitoring and control app for user notification if needed, as discussed above.

At block 718, a determination is made by both the first and second ground fault sensors whether a ground fault is detected by either sensor. If the determination by both the first and second ground fault sensors is no, then the method returns to block 708 where the equipment continues to be operated under normal operating conditions. If the determination by either the first or second ground fault sensor is yes, then at 720, the ground fault interrupting system opens the load side contacts for the ungrounded conductors to interrupt current flow to the HVAC system.

Accordingly, in some embodiments, the ground fault interrupting system for outdoor equipment located at the outlet disconnect location, as described above, includes the following elements:
- A ground fault detection device with two levels of ground fault protection.
- One ground fault sensing circuit for detection of "let-go" level ground fault current normally considered to be in the range of 4-6 mA RMS or other threshold current levels based on other physiological effects. This first ground fault sensing circuit ignores leakage current returning through the grounding conductor. This first ground fault sensing circuit intended to provide "let-go" ground fault protection for the circuit conductors.
- A second ground fault sensing circuit for detection of higher levels of ground fault current in the range of 15 to 20 mA. This second ground fault sensing circuit does not ignore the leakage current returning through the grounding conductor. This second ground fault sensing circuit is intended to provide protection against excessive leakage current from the equipment.
- A set of controlled disconnecting contacts that can be opened to disconnect the ungrounded conductors from the wiring. The set of controlled disconnecting contacts can be opened by the detection of a ground fault from the first ground fault sensing circuit. The set of controlled disconnecting contacts can be opened by the detection of a ground fault from the second ground fault sensing circuit. The set of controlled disconnecting contacts are opened automatically when any of the line side voltage terminals becomes de-energized. The set of controlled disconnecting contacts may be reclosed by a manual interface on the ground fault interrupting device or automatically after a prescribed time delay after a detected ground fault from either of the two detecting circuits. The set of controlled disconnecting contacts can be reclosed by a remote means through a communications system.
- A set of non-controlled contacts for the purpose of manually disconnecting and isolating the equipment from the power source. The set of non-controlled contacts may include a trip function that can operate in the case of an incorrect state of the controllable contacts (e.g., welded contacts).
- The ground fault interrupting device includes two or more line-side voltage terminals. The ground fault interrupting device also includes two or more load current carrying conductor terminals for wire connections. The ground fault interrupting device also includes a service entrance side grounding conductor wire connection. The ground fault interrupting device also includes an equipment side grounding conductor wire connection.
- Wiring between the ground fault interrupting device and the equipment consisting of a minimum of at least two load current carrying conductors and a grounding conductor.
- The ground fault interrupting device may include a communication means for the purpose power monitoring, status, and diagnostics.
- The communications for status and diagnostics include the ability to detect leakage current that is approaching the threshold at which the device is configured to trip (e.g., leakage greater than 10 mA, but still less than the 15-20 mA threshold can be communicated as a status to the user that the system may need servicing). This monitoring, status, and diagnostic information is also available locally on the ground fault interrupting device in the form of a user interface consisting of a display and/or other visual indicators.
- The ground fault interrupting device for the outdoor equipment is located at the outlet/disconnect near the equipment to facilitate convenient servicing and troubleshooting of the equipment.

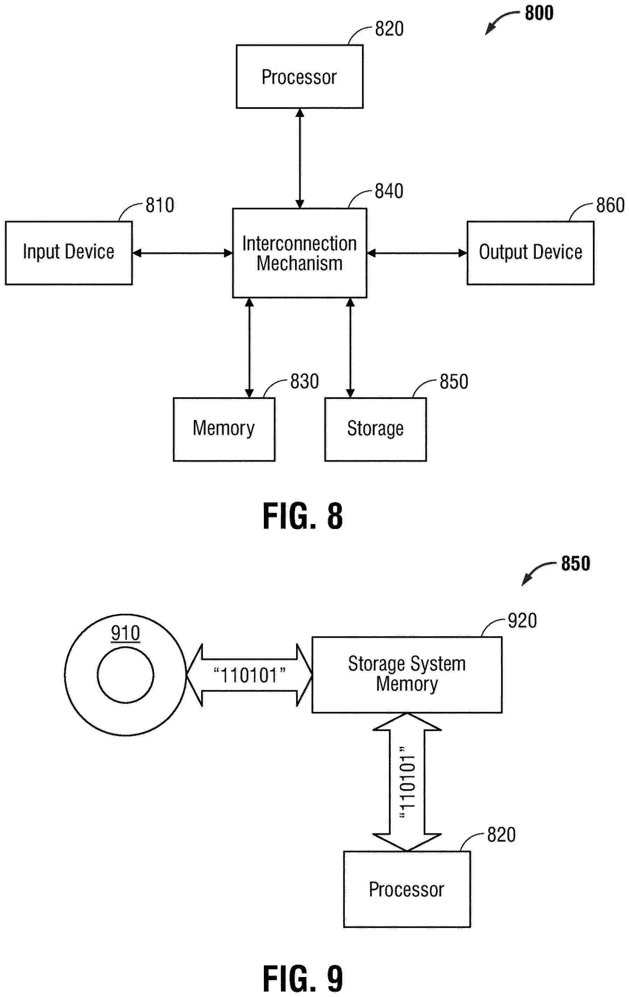

Turning now to FIG. 8, an exemplary controller system 800 is shown that may be used to implement various embodiments of this disclosure, including the supervisory controller and the low current and high current sensors described herein. The controller system 800 may include a processor 820 connected to one or more memory devices 830, such as a solid-state memory or other device for storing data. Memory 830 is typically used for storing programs and data used during operation of the controller system 800. The controller system 800 may also include a storage system 850 that provides additional storage capacity. Components of the controller system 800 may be coupled by an interconnection mechanism 840, which may include one or more busses (e.g., between components that are integrated within the same system) and/or a network (e.g., between components that reside on separate discrete systems). The interconnection mechanism 840 enables communications (e.g., data, instructions) to be exchanged between system components of the system 800.

The controller system 800 also includes one or more input devices 810, including, for example, sensor inputs and user inputs, and one or more output devices 860, including, for example, control signals and display screens. The display screens may include touchscreens and similar user interface screens that allow a user to configure, operate, and otherwise interact with the controller system 800. In addition, the controller system 800 may contain one or more interfaces (not shown) that connect the controller system 800 to a wired or wireless communication network (in addition or as an alternative to the interconnection mechanism 840).

The storage system 850, shown in greater detail in FIG. 9, typically includes a computer readable and writeable nonvolatile recording medium 910 in which signals are stored that define a program to be executed by the processor 820 or information stored on or in the medium 910 to be processed by the program to perform one or more functions associated with embodiments described herein. The medium may be, for example, a flash memory. Typically, in operation, the processor 820 causes data to be read from the nonvolatile recording medium 910 into storage system memory 920 that allows for faster access to the information by the processor than does the medium 910. This storage system memory 920 may be a volatile, random access memory, such as a dynamic random-access memory (DRAM) or static memory (SRAM). This storage system memory 920 may be located in storage system 850, as shown, or in the system memory 830. The processor 820 generally manipulates the data within the memory system 920 and then copies the data to the medium 910 after processing is completed. A variety of mechanisms are known for managing data movement between the medium 910 and the integrated circuit memory element 920, and the disclosure is not limited thereto. The disclosure is not limited to a particular memory 920, memory 830 or storage system 850.

The controller system 800 may include specially programmed, special-purpose hardware, for example, an application-specific integrated circuit (ASIC). Aspects of the disclosure may be implemented in software, hardware or firmware, or any combination thereof. Further, such methods, acts, systems, system elements and components thereof may be implemented as part of the controller system described above or as an independent component. Although the controller system 800 is shown by way of example as one type of controller system upon which various aspects of the disclosure may be practiced, it should be appreciated that aspects of the disclosure are not limited to being implemented on the controller system as shown in FIG. 8.

In the preceding, reference is made to various embodiments. However, the scope of the present disclosure is not limited to the specific described embodiments. Instead, any combination of the described features and elements, whether related to different embodiments or not, is contemplated to implement and practice contemplated embodiments. Furthermore, although embodiments may achieve advantages over other possible solutions or over the prior art, whether or not a particular advantage is achieved by a given embodiment is not limiting of the scope of the present disclosure. Thus, the preceding aspects, features, embodiments and advantages are merely illustrative and are not considered elements or limitations of the appended claims except where explicitly recited in a claim(s).

It will be appreciated that the development of an actual commercial application incorporating aspects of the disclosed embodiments will require many implementation specific decisions to achieve a commercial embodiment. Such implementation specific decisions may include, and likely are not limited to, compliance with system related, business related, government related and other constraints, which may vary by specific implementation, location and from time to time. While a developer's efforts might be considered complex and time consuming, such efforts would nevertheless be a routine undertaking for those of skill in this art having the benefit of this disclosure.

It should also be understood that the embodiments disclosed and taught herein are susceptible to numerous and various modifications and alternative forms. Thus, the use of a singular term, such as, but not limited to, "a" and the like, is not intended as limiting of the number of items. Similarly, any relational terms, such as, but not limited to, "top," "bottom," "left," "right," "upper," "lower," "down," "up," "side," and the like, used in the written description are for clarity in specific reference to the drawings and are not intended to limit the scope of the invention.

This disclosure is not limited in its application to the details of construction and the arrangement of components set forth in the following descriptions or illustrated by the drawings. The disclosure is capable of other embodiments and of being practiced or of being carried out in various ways. Also, the phraseology and terminology used herein is for the purpose of descriptions and should not be regarded as limiting. The use of "including," "comprising," "having," "containing," "involving," and variations herein, are meant to be open-ended, i.e., "including but not limited to."

It should further be understood that the above description is intended to be illustrative, and not restrictive. Many other implementation examples are apparent upon reading and understanding the above description. Although the disclosure describes specific examples, it is recognized that the systems and methods of the disclosure are not limited to the examples described herein but may be practiced with modifications within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

## Claims

1. A ground fault monitoring and detection system, comprising:
a current interrupt switch configured to be connected to power supply lines;
a first leakage sensor connected to the current interrupt switch, the first leakage sensor configured to detect a leakage current in the power supply lines and to control the current interrupt switch to interrupt current through the power supply lines if the leakage current exceeds a first current threshold; and
a second leakage sensor connected to the current interrupt switch, the second leakage sensor configured to detect the leakage current in the power supply lines and to control the current interrupt switch to interrupt current through the power supply lines if the leakage current exceeds a second current threshold;
wherein the first current threshold is a let-go current and the second current threshold is greater than the let-go current by a predefined amount.

2. The system of claim 1, wherein the first leakage sensor comprises a first ground fault interrupt device (GFID) connected to a first current sensor, and the second leakage sensor comprises a second GFID connected to a second current sensor.

3. The system of claim 1, wherein the power supply lines include a first ungrounded conductor, a second ungrounded conductor, and a grounding conductor, and wherein the second leakage sensor is configured to detect the leakage current via the first and second ungrounded conductors, while the first leakage sensor is configured to detect the leakage current via the first and second ungrounded conductors and also the grounding conductor.

4. The system of claim 1, wherein the current interrupt switch is a load side current interrupt switch, the system further comprising a line side current interrupt switch configured to be connected to the power supply lines.

5. The system of claim 4, further comprising a supervisory controller connected to the line side current interrupt switch, the supervisory controller configured to control the line side current interrupt switch to interrupt current flow through the power supply lines upon occurrence of a predefined current interrupt event.

6. The system of claim 4, further comprising a local disconnect handle mechanically coupled to the line side current interrupt switch, the local disconnect handle configured to be operated by a user to manually interrupt current flow through the power supply lines.

7. The system of claim 1, further comprising a housing configured to enclose the current interrupt switch and the first and second leakage sensors, the housing providing weather protection for the current interrupt switch and the first and second leakage sensors.

8. The system of claim 5, wherein the supervisory controller is coupled to the first and second leakage sensors, the supervisory controller configured to perform diagnostics on the leakage current detected by the first and second leakage sensors and provide status and diagnostic information to a user.

9. A method of providing ground fault monitoring and detection, the method comprising:
providing a current interrupt switch configured to be connected to power supply lines;
connecting a first leakage sensor to the current interrupt switch, the first leakage sensor configured to detect a leakage current in the power supply lines and to control the current interrupt switch to interrupt current flow through the power supply lines if the leakage current exceeds a first current threshold; and
connecting a second leakage sensor to the current interrupt switch, the second leakage sensor configured to detect the leakage current in the power supply lines and to control the current interrupt switch to interrupt current flow through the power supply lines if the leakage current exceeds a second current threshold;
wherein the first current threshold is a let-go current and the second current threshold is greater than the let-go current by a predefined amount.

10. The method of claim 9, wherein the first leakage sensor comprises a first ground fault interrupt device (GFID) connected to a first current sensor, and the second leakage sensor comprises a second GFID connected to a second current sensor.

11. The method of claim 9, wherein the power supply lines include a first ungrounded conductor, a second ungrounded conductor, and a grounding conductor, further comprising connecting the second leakage sensor to detect the leakage current via the first and second ungrounded conductors, and connecting the first leakage sensor to detect the leakage current via the first and second ungrounded conductors and also the grounding conductor.

12. The method of claim 9, wherein the current interrupt switch is a load side current interrupt switch, the method further comprising connecting a line side current interrupt switch to the power supply lines.

13. The method of claim 12, further comprising connecting a supervisory controller to the line side current interrupt switch, the supervisory controller configured to control the line side current interrupt switch to interrupt current flow through the power supply lines upon occurrence of a predefined current interrupt event.

14. The method of claim 12, further comprising mechanically coupling a local disconnect handle to the line side current interrupt switch, the local disconnect handle configured to be operated by a user to manually interrupt current flow through the power supply lines.

15. The method of claim 9, further comprising enclosing the current interrupt switch and the first and second leakage sensors in a housing, the housing configured to provide weather protection for the current interrupt switch and the first and second leakage sensors.

16. The method of claim 13, further comprising coupling the supervisory controller to the first and second leakage sensors, the supervisory controller configured to perform diagnostics on the leakage current detected by the first and second leakage sensors and provide status and diagnostic information to a user.

17. A heating, ventilating, and air conditioning (HVAC) system, the HVAC system comprising:
an electrical panel;
power supply lines connected to the electrical panel;
HVAC equipment connected to the power supply lines;
a current interrupt switch connected to the power supply lines between the electrical panel and the HVAC equipment;
a first leakage sensor connected to the current interrupt switch, the first leakage sensor configured to detect a leakage current in the power supply lines and to control the current interrupt switch to interrupt current to the HVAC equipment if the leakage current exceeds a first current threshold; and
a second leakage sensor connected to the current interrupt switch, the second leakage sensor configured to detect the leakage current in the power supply lines and to control the current interrupt switch to interrupt current to the HVAC equipment if the leakage current exceeds a second current threshold;
wherein the first current threshold is a let-go current and the second current threshold is greater than the let-go current by a predefined amount.

18. The HVAC system of claim 17, wherein the first leakage sensor comprises a first ground fault interrupt device (GFID) connected to a first current sensor, and the second leakage sensor comprises a second GFID connected to a second current sensor.

19. The HVAC system of claim 17, wherein the power supply lines include a first ungrounded conductor, a second ungrounded conductor, and a grounding conductor, and wherein the second leakage sensor is configured to detect the leakage current via the first and second ungrounded conductors, while the first leakage sensor is configured to detect the leakage current via the first and second ungrounded conductors and also the grounding conductor.

20. The HVAC system of claim 17, wherein the current interrupt switch is a load side current interrupt switch, the HVAC system further comprising a line side current interrupt switch configured to be connected to the power supply lines between the electrical panel and the HVAC equipment.

21. The HVAC system of claim 20, further comprising a supervisory controller connected to the line side current interrupt switch, the supervisory controller configured to control the line side current interrupt switch to interrupt current flow to the HVAC equipment upon occurrence of a predefined current interrupt event.

22. The HVAC system of claim 20, further comprising a local disconnect handle mechanically coupled to the line side current interrupt switch, the local disconnect handle configured to be operated by a user to manually interrupt current flow to the HVAC equipment.

23. The HVAC system of claim 17, further comprising a housing configured to enclose the current interrupt switch and the first and second leakage sensors, the housing providing weather protection for the current interrupt switch and the first and second leakage sensors.

24. The HVAC system of claim 21, wherein the supervisory controller is coupled to the first and second leakage sensors, the supervisory controller configured to perform diagnostics on the leakage current detected by the first and second leakage sensors and provide status and diagnostic information to a user.
